# EUROPEAN PATENT SPECIFICATION

(11) **EP 0 746 929 B1**
(45) Date of publication and mention of the grant of the patent: **28.11.2001**
(21) Application number: 95912591.5
(22) Date of filing: 23.02.1995
(51) Int. Cl.: H04L 25/02, H03K 5/02, H03K 5/24, H03F 3/45

(54) **HIGH SPEED DIFFERENTIAL RECEIVER FOR DATA COMMUNICATIONS**
SCHNELLER, DIFFERENZIELLER EMPFÄNGER FÜR DATENÜBERTRAGUNG
RECEPTEUR DIFFERENTIEL A GRANDE VITESSE POUR LA TRANSMISSION DE DONNEES

(30) Priority: 23.02.1994 US 200478
(43) Date of publication of application: 11.12.1996
(73) Proprietor: APPLE COMPUTER, INC., Cupertino, California 95014 (US)
(72) Inventor: VAN BRUNT, Roger, W., San Francisco, CA 94117 (US); OPRESCU, Florin, A., Sunnyvale, CA 94087 (US)
(74) Representative: Wombwell, Francis
(86) International application number: US9502257
(87) International publication number: WO9523472

(56) References cited:
- WO-A-92/17938
- US-A- 5 175 533
- PROCEEDINGS OF THE INTERNATIONAL SYMPOSIUM ON CIRCUITS AND SYSTEMS (ISCS), CHICAGO, MAY 3 - 6, 1993, vol. 2 OF 4, 3 May 1993 INSTITUTE OF ELECTRICAL AND ELECTRONICS ENGINEERS, pages 1443-1446, XP 000379247 HUIJSING J H ET AL 'LOW-VOLTAGE LOW-POWER AMPLIFIERS'

## Description

### BACKGROUND OF THE INVENTION

### 1. Field of the Invention

The present invention relates to the field of data communications. More particularly, the present invention relates to converting high speed differential serial transmission signals to single-ended CMOS logic circuit level signals.

### 2. Description of Related Art

It is well-known in the data communications field that for the transmission of high bit rate data signals small differential signals provide a number of advantages. A differential channel provides rejection of common mode noise present between a transmitting and receiving node such as power supply noise. Differential signals can be transmitted on twisted pair cables which are less expensive than coaxial or fiber optic cables and which when shielded offer very good rejection of interference from external noise sources. Using small signal level differential signals on a shielded twisted pair cable reduces EMI emissions, simplifies transmitter design and reduces power dissipation.

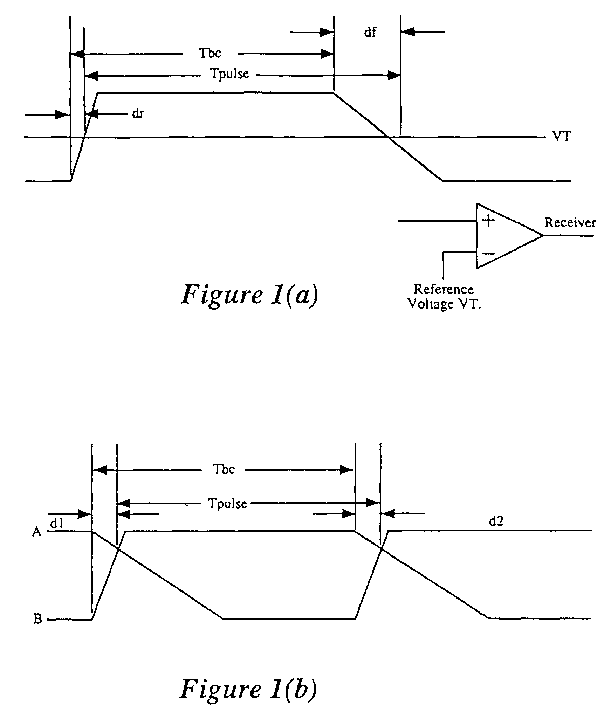

One of the most important characteristics of a differential communication channel is that it reduces offset or timing distortion due to mismatched rise and fall times and receiver threshold. Timing distortion must be minimized since in a digital communication system data is encoded in both time and amplitude. **Figure 1(a)** illustrates a single-ended system with mismatched rise and fall times and a threshold VT. As can be seen the mismatch in rise and fall times causes duty cycle distortion (Tpulse does not equal T_{bc} where T_{bc} is the bit cell width and Tpulse is the received pulse width.) It is very difficult in a single-ended communication system to match the rise and fall times and this mismatch becomes significant when data rates become high (50 Mbaud or more).

Differential systems on the other hand do not suffer duty cycle distortion due to rise and fall time mismatch. As shown in **Figure 1(b)**, as long as signal A and B have equivalent rise times and equivalent fall times the signal's pulse width is preserved. This type of matching is much more simple to guarantee in an integrated circuit design that has a symmetric layout for the A and B signals. It is also important to note that in a differential receiver the threshold is not set externally as in the single-ended system which was set by the VT reference shown in **Figure 1(a).** Instead, the threshold in a differential system is a function of the received signal and therefore tracks with the received signal corresponding to when A=B (the signal crossing point).

Circuits composed of CMOS digital logic generally require signal swings having a range of 5 or 3 volts, usually between +5 volts and 0 volts or +3 to 0 volts. When a CMOS circuit receives a small amplitude differential binary signal, it is necessary to convert the binary differential signal into a single-ended signal amplified to CMOS digital voltage levels usable by the CMOS logic. As data transmission rates increase, it is necessary that the signal conversion circuitry be able to handle ever faster incoming differential signals for conversion to digital levels.

It is desirable in many situations to implement a signal receiver directly on the same integrated circuit chip as many other digital logic circuits. Circuits implemented on large digital chips generally operate from a common power supply and are thus subjected to severe power supply noise. In very large scale integrated circuits, the power supply noise may be many times the strength of the signal level of incoming signal transmissions. This power supply noise can degrade or totally obliterate the useful information in a received signal.

In other technology areas it has been necessary to convert signals from one domain to another domain. U.S. Patent 4,437,171 illustrates circuitry for converting ECL level signals to signals suitable for use by a MOS memory.

### SUMMARY OF THE INVENTION

From the foregoing it can be appreciated that there is a need for a serial data transmission receiver which receives a high speed differential signal and converts it to a single-ended signal at digital logic levels. It is also desirable that such a receiver have a high bandwidth, provide good common mode input signal rejection over a wide common mode range and suffer minimal timing distortion or offset. Further, such a receiver should require a minimal amount of silicon die area and operate with low power, low power supply voltages such as 3V, with good power supply noise rejection.

These and other objects of the present invention are provided by a differential-to-CMOS level signal conversion apparatus which receives a binary differential input signal having a small amplitude. The receiver can be described as operating in two stages. The first stage is the differential-to-single-ended conversion stage in which the received differential signal is input into a differential folded cascode transconductor. The transconductor incorporates both P-channel and N-channel cascode circuitry and a tail current transistor used to bias an input transistor pair. Biasing voltages are supplied by a biasing circuit that requires an external reference current. The transconductor converts the differential voltage inputs into a single-ended current which is output into a tied-back inverter and a next amplifying inverter. The combination of the differential folded cascode transconductor, tied-back inverter and the next amplifying inverter provide for very good power supply noise rejection since the power supply noise is coupled as a common mode signal input and rejected by the equivalent circuit differential transconductor.

The second stage of the differential receiver circuit is a series of CMOS amplifiers which first raise the signal level of the first stage output to the desired CMOS digital logic levels. The signal is also strengthened through the chain of amplifiers. The inverter amplifiers can be considered class AB amplifiers and have favorable slew rates thus providing rapid signal rise and fall times. Finally, the output of the second stage may be driven through a tri-state bus driver for applications in which the receiver is implemented on a bus.

Additional features of the receiver include on/off switches which allow a disabled receiver to sit at either a high logic level or a low logic level depending on implementation. The high speed differential receiver circuit of the present invention, if driven with 3-volt power supply operates to produce 3-volt digital CMOS logic levels and if driven with a 5-volt power supply produces 5-volt logic levels.

### BRIEF DESCRIPTION OF THE DRAWINGS

The objects, features and advantages of the present invention will be apparent from the following detailed description in which:
**Figures 1(a)** and **1(b)** illustrate graphically a single-ended signal and a differential signal, comparing characteristics of duty-cycle or timing distortion.
**Figure 2** illustrates a block equivalent circuit of the differential-to-CMOS converter and amplifier in accordance with the present invention.
**Figures 3(a), 3(b)** and **3(c)** provide an equivalent circuit diagram for explaining some of the favorable characteristics of the design of the present invention.
**Figure 4** illustrates a transistor level diagram of portions of the differential receiver circuit in accordance with a preferred embodiment of the present invention.
**Figure 5** illustrates a transistor level circuit diagram of the biasing circuit used for driving the differential receiver of the present invention.

### DETAILED DESCRIPTION OF THE INVENTION

A method and apparatus are described for the conversion and amplification of high bandwidth, binary, small amplitude differential serial data transmission signals to single-ended digital CMOS level signals. In the following description, many specific details are set forth such as relative voltage levels and transistor sizes, etc., in order to provide a thorough description of the present invention. It will be appreciated, however, by one of ordinary skill in the art that the present invention may be practiced without such specific details. In other instances, well-known structures and techniques have not been described in detail in order not to obscure unnecessarily the present invention.

The preferred embodiment of the present invention is intended to be incorporated into a data bus receiving module for use in a data communications system where information is transmitted in serial binary format at a very high rate of speed. Particularly, a preferred embodiment of the present invention is intended to be incorporated in a data communication system complying with the IEEE Standard P1394, "High Performance Serial Bus" wherein data is serially transmitted over a twisted-pair cable from a transmitter on one node to a receiver on another node. However, those of ordinary skill in the art will see that the present invention may be implemented in a wider field of use.

In light of the reasons discussed in the previous section, it can be seen that it is desirable in high speed serial transmission systems to use differential signals to advantageously limit timing distortion and to reduce other negative effects that are present when transmitting single-ended signals. It is thus necessary to provide the means for converting low voltage differential signals to single-ended signals at digital logic levels for use by digital circuitry. At very high speeds, and low voltage, it is essential that the serial receiver provide good common mode input signal rejection over a wide common mode range as well as suffering very little timing distortion. Likewise, it is desirable that the receiver require low power and a small amount of silicon die area while also providing good power supply noise rejection.

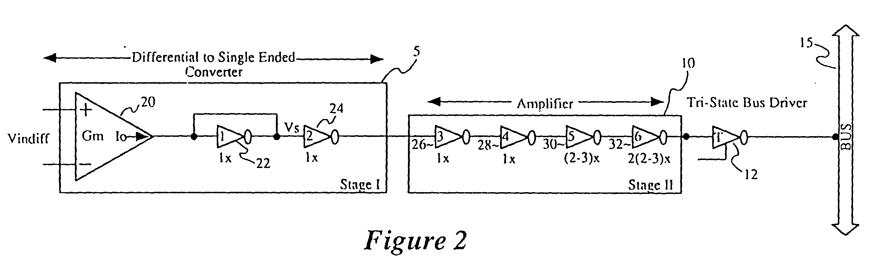

Referring now to **Figure 2**, an equivalent circuit of the receiver of the present invention is illustrated. The preferred embodiment receiver is intended to be implemented in a system implementing the IEEE P1394, "High Speed Serial Bus" standard. This standard provides for the transmission of serial data by means of a differential signal over a twisted pair cable and exhibiting a peak-to-peak swing of 300 millivolts. The small amplitude differential signal, in order to be useful to digital logic circuits must be amplified to either a 0 to 3 volt range or 0 to 5 volt range for standard CMOS applications. As illustrated in **Figure 2,** the differential receiver of the present invention is shown having two salient stages. The first stage 5 receives the small amplitude differential signal from the twisted-pair coupling and converts it to a single-ended signal with some amplification. The second stage 10 receives the output of the first stage and further raises the signal level to CMOS digital logic levels and further increases the strength of the signal. The output from stage two may be used directly as the CMOS level digital signal, or the output may be passed through a tri-state bus driver 12 which couples the receiver to a bus 15 for conveying the single-ended signal to the desired location.

The elegance of the present invention can be found in the design of the first stage 5 of the differential receiver. Bearing in mind that for a receiver to operate at a very high speed on low amplitude differential signals, the receiver must provide good common mode input signal rejection over a wide common mode range while also providing good power supply noise rejection. Accordingly, the input to the receiver is a differential folded cascode transconductor 20. It should be understood that the input signal received by the transconductor 20 comprises two components: the differential signal transmitted by a transmitter with some biasing voltage at the other end of the cable, and a common mode component which manifests itself and is considered interference on the twisted-pair cable. The differential signal has opposite values on the two constituents of the twisted-pair cable, and thus the differential components of the signal entering the two inputs of the transconductor have opposite values. The common mode signal picked up by the twisted-pair has an equivalent value on both cables entering the receiver. Because the receiver is a differential transconductor, the equivalent signals are canceled out and only the differential signal is processed by the receiver circuit. Using the differential transconductor 20 thus provides for good common mode input signal rejection for the receiver. For reasons that will be described further herein with respect to the particular circuitry used to implement the transconductor, the receiver of the present invention provides good common mode rejection over a common mode range of approximately 1.2 to 3.0 volts for a 3-volt CMOS implementation and 1.2 to 5.0 volts for a 5-volt CMOS implementation.

The output of the transconductor 20 is provided to a first inverter 22 which is tied-back for self-biasing. The signal is then inverted and further amplified by the inverter 24 to complete the signal processing carried out by the first stage 5 of the differential receiver of the present invention. In the preferred embodiment, inverters 22 and 24 are the same size.

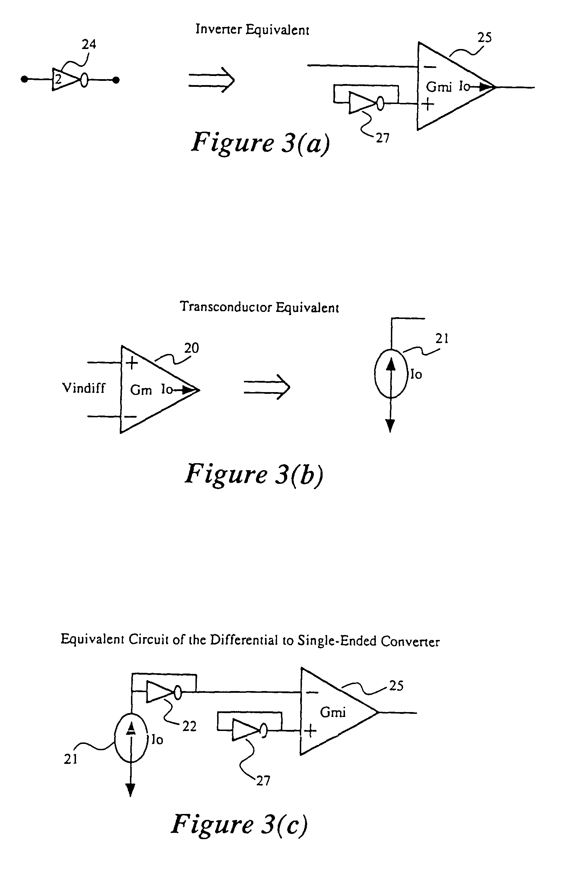

Because the differential receiver of the present invention is designed to be implemented on highly integrated circuits, it is important that the receiver provide good power supply noise rejection. Power supply noise is inherently present in highly integrated semiconductor circuits. In fact, the power supply noise can be several times the size of the signal that the receiver is supposed to be detecting. To this end, it will be seen that the circuit design of the first stage 5 provides an elegant solution to the need for rejecting power supply noise. This will be explained with reference to **Figures 3(a)-3(c).** In **Figure 3(a)**, it is shown that the inverter 24 can be alternatively illustrated as a differential transconductor 25 having a tied-back or self-biasing inverter 27 coupled to one input. Upon careful consideration, it will be understood by those of ordinary skill in the art that these are equivalent circuit representations wherein the inverter can be considered an ideal transconductor with its threshold equivalent to the threshold of an inverter having the same transistor size ratio. **Figure 3(b)** illustrates that the differential folded cascode transconductor 20 which receives the differential input signal can be illustrated more simply as a current source 21 that can source or sink current. Thus, **Figure 3(c)** shows an equivalent circuit to the first stage 5 of the differential receiver of the present invention.

The equivalent circuit shown in **Figure 3(c)** shows a differential transconductor 25 which has at one input the tied-back or self-biasing inverter 27 as well as the tied-back or self-biasing inverter 22 which was described above with respect to **Figure 2** and is the same size as inverter 27. The current source 21 sources or sinks current through one of these two inputs, shown being injected through self-biasing inverter 22. As was described above, it is only the differential inputs to a differential transconductor that are processed while common mode input signals are rejected. It can therefore be seen from the equivalent circuit of **Figure 3(c)** that the first stage 5 portion of the differential receiver of the present invention provides very good power supply noise rejection since the power supply noise is coupled as a common mode input signal through the two self-biasing inverters and is rejected by the differential transconductor. This is true even though inverters alone generally exhibit poor power supply noise rejection. Only the differential signal, which in this case is the injected current from the current source 21, is yielded from the first stage 5 of the differential receiver. It should be noted that to facilitate this coupling of power supply noise as a common mode input signal that the transistors utilized for the inverters 22 and 24 should have the same transistor sizes.

Referring back now to **Figure 2,** it is now understood that the novel circuit design of the first stage 5 of the differential receiver provides for good common mode input signal rejection over a wide common mode range as well as providing good power supply noise rejection. The single-ended output signal from the first stage 5 is next propagated to the second stage of the differential receiver, the amplifying stage 10. In this stage, the single-ended signal is now propagated through a string of inverters which serve to raise the single-ended signal to CMOS logic levels and further amplify the signal to a useful strength. It turns out that it is faster to use a chain of inverters because a single larger inverter will have the effect of slowing down the node. These inverters are typical CMOS inverters comprising two transistors each which can be processed efficiently by known technologies. In a preferred embodiment implementation, inverters 26 and 28 utilize the same size transistors as inverters 22 and 24 while inverter 30 may be in the range of two to three times that size and inverter 32 may have transistors twice again the size of the transistors of inverter 30. It is important in implementing the present invention, at least for the preferred embodiment implementation, that the inverters 22, 24, 26, 28, 30 and 32 all use transistors of the same size and ratio, although for signal strengthening as described, inverters 30 and 32 implement multiple transistors. It will be understood that the inverters are intrinsic class AB amplifiers which, once switched to the rails do not use any power. This facilitates a low power aspect in designing an efficient receiver in accordance with the present invention. Likewise, the design provides for a favorable slew rate yielding very fast signal rise and fall times in providing a very high speed receiver for serial data transmissions.

Those of ordinary skill in the art may envision alternative circuitry for amplifying the output from the first stage of the receiver. The output from the second stage of the receiver circuit illustrated in **Figure 2** may directly be used to drive digital CMOS logic circuits, or it may be passed through tri-state bus driver 12 for coupling the receiver to a bus 15.

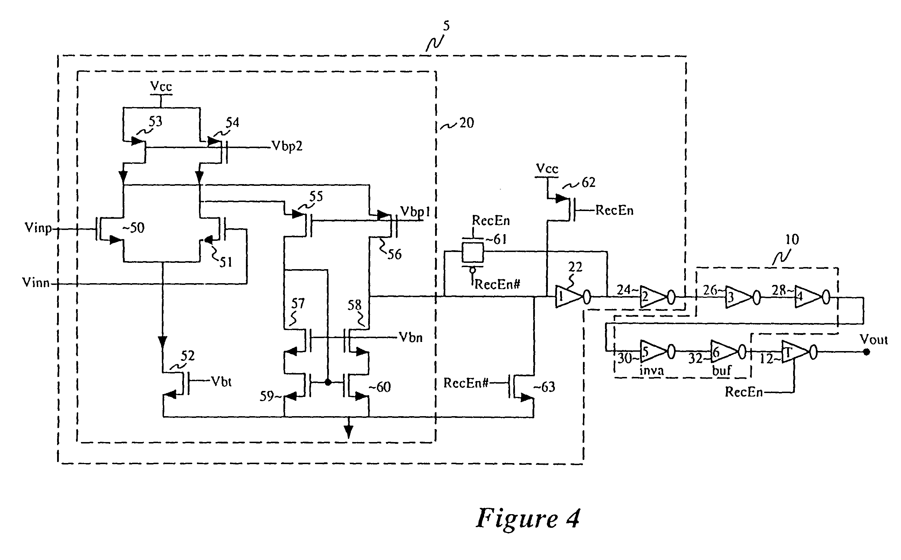

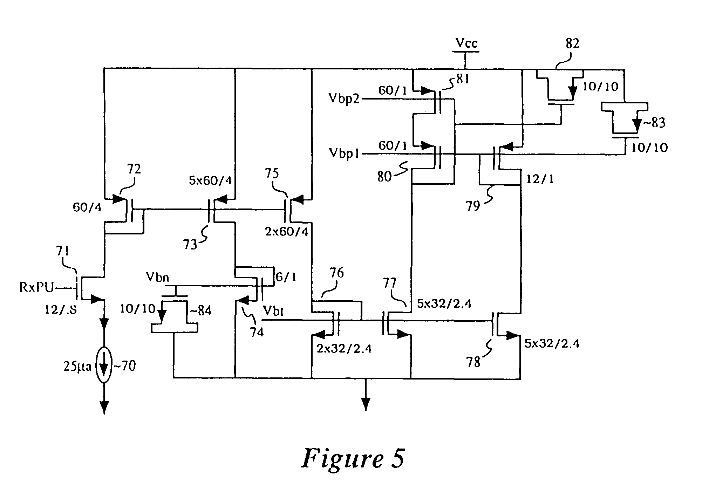

Referring now to **Figure 4,** a more detailed circuit diagram of the differential receiver of the present invention is illustrated. In this figure, the circuitry for the differential folded cascode transconductor 20 is illustrated at the transistor level. It can be seen that the differential signal is inputted to the transconductor through differential NMOS input transistors 50 and 51. The sources of the two NMOS differential transistors 50 and 51 are coupled to the drain of tail current source transistor 52 which has its gate coupled to a biasing circuit to be described further herein with respect to **Figure 5.** The tail current transistor 52 is used to provide current flow in the differential input transistor pair.

The differential folded cascode transconductor 20 further incorporates PMOS transistors 53, 54, 55 and 56 which are coupled together to provide a P-channel folded cascode circuit. These transistors also receive their biasing gate voltages from the biasing circuit to be described further herein with respect to **Figure 5.** Finally, NMOS transistors 57, 58, 59 and 60 are coupled together to form the N-channel cascode current mirror circuit. The biasing voltage Vbn to the N-channel cascode circuit is also provided from the biasing circuit to be described further herein with respect to **Figure 5.** Those with an understanding of circuit design will see that the N-channel and P-channel cascode circuits are coupled in an arrangement such that the current drawn through differential input transistors 50 and 51 is folded through the circuit and forced to propagate to self-biasing inverter 22. Transistors 50 through 60 are biased in the saturation region. The currents in transistors 53 and 54 are equal and are typically about 25% higher than the current in transistor 52. It should be understood that the polarities for the transistors described above are chosen to suit the common mode range of the preferred embodiment implementation. Over a different common mode range, those of ordinary skill in the art will appreciate that the differential folded cascode transconductor 20 could be implemented with the transistor polarities reversed (i.e., p-transistors switched for n-transistors and vice versa).

The circuit diagram of **Figure 4** also illustrates a switch 61 being inserted within the circuit of the tied-back inverter 22. The switch 61 should be sized such that its transconductance gm is much larger than the gm of the tied-back inverter 22. This is used for disabling the receiver controllably based on an enable signal supplied thereto. Because the inverters are intrinsic class AB inverters which will draw no power once either fully in the on or fully in the off state, the receiver should be implemented such that it exhibits a low logic signal constantly or a high logic signal constantly when it is off. There is shown in **Figure 4** two switching transistors, PMOS transistor 62 with its source tied to Vcc and NMOS transistor 63 with its source tied to ground. These are alternative transistors, with one providing the output to be exhibited in a low state and the other causing the output to be exhibited in a high state. By implementing and turning on PMOS switching transistor 62 when the circuit receiver is disabled, the output from the tied-back inverter 22 will be a CMOS low which results in a low Vout because of the even number of inverters present. Alternatively, by having present and turning on NMOS switching transistor 63, when the circuit receiver is disabled, the output from the tied-back inverter 22 will be CMOS high, resulting in a high output due to the even number of inverters. Transistors 62 or 63 must be strong enough to overcome the output current of the stage 20 and force the output of the inverter 22 to the appropriate CMOS level.

In the preferred embodiment implementation of the present invention, the transistor sizes for the circuit, measured in microns, are as follows: for the differential input transistor pair, the NMOS transistors have the dimensions of 2 x 120/1.2. The P-channel cascode circuit transistors 53, 54, 55 and 56 are all 60/1 and the NMOS transistors 57, 58, 59 and 60 of the N-channel cascode circuit are 30/1. Transistor 52 is 4 x 32/2.4. Finally, if the PMOS switch 62 is implemented its dimensions are 8/0.8 while an NMOS switch 63 if implemented is 5/0.8. For the inverters 22, 24, 26 and 28, the N-channel transistors are 3/0.8 and the P-channel transistors are 6/0.8. Inverter 30 is sized with multiples of the other inverters with the N-channel transistor being 2 x 3/0.8 and the P-channel transistor being 2 x 6/0.8. Similarly, the N-channel transistor of inverter 32 is 4 x 3/0.8 and the P-channel transistor is 4 x 6/0.8.

Referring now to **Figure 5,** the circuit implemented for biasing up the differential folded cascode transconductor 20 is illustrated. The biasing circuit requires an independent external current source 70 which provides 25 µamps to NMOS transistor 71 in the preferred embodiment. The NMOS transistor 71 operates as a switch controlled by a receiver power-up which, when open prevents current from flowing in the rest of the biasing circuit. This also shuts down the current in the transconductor circuit stage 20 as described above with respect to **Figure 4.**

When the switching transistor 71 is closed, a current from the current source is mirrored through the rest of the circuit. The current is mirrored by PMOS transistors 72 and 73 and flows into diode-connected N-channel transistor 74 which supplies the gate voltage to the N-channel cascode circuit. The current also gets mirrored at PMOS transistor 75 and flows into diode-connected N-channel transistor 76 which sets up the bias voltage to the tail current transistor 52 of **Figure 4.** The current is then mirrored by NMOS transistors 78 and 77 which sets up a current that flows through diode connected PMOS transistor 79 and transistors 80, 81, respectively. This sets up the bias voltage for the P-channel cascode circuit described above with respect to **Figure 4.** The transistors 81, 82 and 84 are used as decoupling capacitors. The transistor sizing for the preferred embodiment, in microns, is illustrated in **Figure 5** using conventions understood by those of ordinary skill in the art.

There has thus been described a method and apparatus for the reception of high speed small amplitude differential signals and the conversion of those signals into single-ended digital logic levels. Although the present invention has been described in terms of a preferred implemented embodiment, it will be appreciated that various modifications and alterations might be made by those of ordinary skill in the art without departing from the scope of the present invention. The invention should, therefore, be measured in terms of the claims which follow.

## Claims

1. An apparatus for converting a small amplitude differential signal (V_{indiff}) to a single-ended signal suitable for use in digital logic circuits, said apparatus comprising:
a first stage circuit (5) for receiving said small amplitude differential signal, said first stage circuit rejecting substantially all common mode input signal received and substantially all power supply noise received, said first stage circuit further converting said small amplitude differential signal into a single-ended signal, and
a second stage amplifying circuit (10) coupled to said first stage circuit (5) for amplifying said single-ended signal to digital logic signal levels.

2. The apparatus of claim 1 wherein said first stage circuit comprises:
a differential transconductor (20, 21) for receiving said small amplitude differential signal and rejecting any common mode input received therewith, said differential transconductor converting said small amplitude differential voltage signal to a single-ended current signal;
a first inverter (22) coupled to said differential transconductor (20, 21), said first inverter having an input and an output wherein said output is coupled to said input to self-bias said first inverter; and
a second inverter (24) coupled to the output of said first inverter (22) which rejects power supply noise present in the first inverter.

3. The apparatus of claim 2 wherein said first and second inverters (22, 24) have equivalent sized transistor pairs.

4. The apparatus of claim 2 wherein said second stage amplifying circuit (10) comprises a plurality of inverters (26, 28, 30, 32) in a chain, each for progressively inverting and amplifying a single-ended signal received from said first stage, raising and strengthening said signal to levels suitable for operating digital logic circuits.

5. The apparatus of claim 4 wherein each of said plurality of inverters (26, 28, 30, 32) in a chain have transistor pairs of the same size using multiple transistors to increase the signal strength.

6. The apparatus of claim 4 wherein said plurality of inverters in a chain comprises:
third and fourth inverters (26, 28) having equivalent size transistor pairs, said transistor pairs equivalent to the size of the transistor pairs in said first and second inverters (22, 24);
a fifth inverter (30) having a transistor pair with dimensions of two to three times the size of the transistor pairs in said third and fourth inverters; and
a sixth inverter (32) having a transistor pair with dimensions of two times the size of the transistor pair in said fifth inverter.

7. The apparatus of claim 2 wherein said differential transconductor is a differential folded cascode transconductor (20).

8. The apparatus of claim 7 wherein said differential folded cascode transconductor (20) comprises:
a pair of input transistors (50, 51) coupled to receive said small amplitude differential signal;
a p-channel cascode circuit (53-56) coupled to said pair of input transistors; and
an n-channel cascode circuit (57-60) coupled to said p-channel cascode circuit,
wherein current pulled through said transconductor is folded and forced to propagate to said first inverter (22).

9. The apparatus of claim 8 wherein said differential folded cascode transconductor (20) further comprises a tail current transistor (52) coupled to said pair of input transistors (50, 51) for pulling current through said pair of input transistors.

10. The apparatus of claim 9 further comprising biasing circuitr (fig. 5) for biasing said tail current transistor (52), said p-channel cascode circuit (53-56) and said n-channel cascode circuit (57-60).

11. The apparatus of claim 10 wherein said biasing circuitry comprises an external current source (70) and a switching transistor (71) for shutting down said biasing circuit and said differential folded cascode transconductor (20).

12. The apparatus of claim 4 further comprising a tri-state driver (12) for selectively coupling said apparatus to a bus (15).

13. The apparatus of claim 4 further comprising means (63) for outputting a high logic signal from said apparatus when said apparatus is in an off state.

14. The apparatus of claim 4 further comprising means (62) for outputting a low logic signal from said apparatus when said apparatus is in an off state.

15. A method for converting a small amplitude differential signal (V_{indiff}) to a single-ended signal suitable for use in digital logic circuits, said method comprising the steps of:
receiving said small amplitude differential signal (V_{indiff}) into a differential folded cascode transconductor (20) to produce a first result signal;
propagating said first result signal to a selfbiasing inverter (22) to produce a second result signal;
propagating said second result signal through a second inverter (24) to produce a third result signal, wherein said third result signal is a single-ended signal having all common mode input from said small amplitude differential signal rejected and power supply noise rejected; and
amplifying said third result signal to digital logic levels.

16. The method of claim 15 wherein said amplifying step comprises the step of propagating said third result signal through a chain of coupled inverter circuits (26, 28, 30, 32).

17. The method of claim 15 further comprising the step of supplying biasing voltages to said differential folded cascode transconductor to operate said transconductor and to selectively turn off said transconductor.

18. The method of claim 15 further comprising the step of tri-stating said amplified signal selectively onto a bus.

19. An apparatus for converting a small amplitude differential signal (V_{indiff}) to a single-ended signal suitable for use in digital logic circuits, said apparatus comprising:
a differential transconductor (20) for receiving said small amplitude differential signal (V_{indiff}) and rejecting any common mode input received therewith, said differential transconductor converting said small amplitude differential signal to a single-ended signal;
a first inverter (22) coupled to said differential transconductor, said first inverter having an input and an output wherein said output is coupled to said input to self-bias said first inverter;
a second inverter (24) coupled to the output of said first inverter, which rejects power supply noise present in the first inverter (22); and
an amplifying circuit (10) coupled to said second inverter for amplifying a resulting signal to digital logic levels.

20. The apparatus of claim 19 wherein said amplifying circuit (10) comprises a plurality of inverter circuits (26, 28, 30, 32) in a chain to produce an amplified signal at digital logic levels.

## Patentansprüche

1. Eine Einrichtung zum Konvertieren eines Differenzsignals geringer Amplitude (V_{indiff}) in ein asymmetrisches Signal, das zur Verwendung in digitalen Logikschaltungen geeignet ist, wobei die Einrichtung aufweist:
eine erste Schaltungsstufe (5) zum Empfangen des Differenzsignals geringer Amplitude, wobei die erste Schaltungsstufe im wesentlichen das gesamte empfangene Gleichtakteingangssignal und im wesentlichen das gesamte empfangene Stromversorgungsrauschen unterdrückt, wobei die erste Schaltungsstufe ferner das Differenzsignal geringer Amplitude in ein asymmetrisches Signal konvertiert, und
eine mit der ersten Schaltungsstufe (5) gekoppelte zweite verstärkende Schaltungsstufe (10) zum Verstärken des asymmetrischen Signals auf digitale Logiksignalpegel.

2. Die Einrichtung nach Anspruch 1, wobei die erste Schaltungsstufe aufweist:
einen Transkonduktanz-Differenzverstärker (20, 21) zum Empfangen des Differenzsignals geringer Amplitude und zum Unterdrücken des darin enthaltenen Gleichtakteingangssignals, wobei der Transkonduktanz-Differenzverstärker das Differenzspannungssignal geringer Amplitude in ein asymmetrisches Stromsignal konvertiert;
einen mit dem Transkonduktanz-Differenzverstärker (20, 21) gekoppelten ersten Inverter (22), wobei der erste Inverter einen Eingang und einen Ausgang aufweist, wobei der Ausgang mit dem Eingang gekoppelt ist, um den ersten Inverter selbst-vorzuspannen; und
einen mit dem Ausgang des ersten Inverters (22) gekoppelten zweiten Inverter (24), welcher das in dem ersten Inverter vorhandene Stromversorgungsrauschen unterdrückt.

3. Die Einrichtung nach Anspruch 2, wobei der erste und der zweite Inverter (20, 24) gleich dimensionierte Transistorpaare aufweisen.

4. Die Einrichtung nach Anspruch 2, wobei die zweite verstärkende Schaltungsstufe (10) eine Mehrzahl von Invertern (26, 28, 30, 32) in einer Kette aufweist, die jeweils dem Invertieren und zunehmenden Verstärken eines aus der ersten Stufe empfangenen asymmetrischen Signals dienen, wobei das Signal gestärkt und auf zum Betreiben digitaler Logikschaltungen geeignete Pegel angehoben wird.

5. Die Einrichtung nach Anspruch 4, wobei jeder der Mehrzahl von Invertern (26, 28, 30, 32) in einer Kette Transistorpaare der gleichen Größe aufweist, wobei Mehrfach-Transistoren verwendet werden, um die Signalstärke zu erhöhen.

6. Die Einrichtung nach Anspruch 4, wobei die Mehrzahl von Invertern in einer Kette umfaßt:
einen dritten und einen vierten Inverter (26, 28), die gleich dimensionierte Transistorpaare aufweisen, wobei die Transistorpaare gleich der Größe der Transistorpaare in dem ersten und dem zweiten Inverter (22, 24) sind;
einen fünften Inverter (30), der ein Transistorpaar mit Dimensionen von etwa dem Zwei- bis Dreifachen der Größe des Transistorpaars in dem dritten bzw. vierten Inverter aufweist; und
einen sechsten Inverter (32), der ein Transistorpaar mit Dimensionen von etwa dem Zweifachen der Größe des Tranistorpaars in dem fünften Inverter aufweist.

7. Die Einrichtung nach Anspruch 2, wobei der Transkonduktanz-Differenzverstärker ein Folded-Cascode-Transkonduktanz-Differenzverstärker (20) ist.

8. Die Einrichtung nach Anspruch 7, wobei der Folded-Cascode-Transkonduktanz-Differenzverstärker (20) aufweist:
ein Paar Eingangstransistoren (50, 51), die zum Empfangen des Differenzsignals geringer Amplitude eingekoppelt sind;
eine mit dem Paar von Eingangstransistoren gekoppelte p-Kanal-Kaskodenschaltung (53-56); und
eine mit der p-Kanal-Kaskodenschaltung gekoppelte n-Kanal-Kaskodenschaltung (57-60),
wobei der durch den Transkonduktanzverstärker gezogene Strom gespiegelt (folded) und gezwungen wird, sich zu dem ersten Inverter (22) auszubreiten.

9. Die Einrichtung nach Anspruch 8, wobei der Folded-Cascode-Transkonduktanz-Differenzverstärker (20) ferner einen Tail-Strom-Transistor (52) aufweist, der mit dem Paar der Eingangstransistoren (50, 51) gekoppelt ist, um einen Strom durch das Paar der Eingangstransistoren zu ziehen.

10. Die Einrichtung nach Anspruch 9, ferner umfassend eine Vorspannschaltung (Fig. 5) zum Vorspannen des Tail-Strom-Transistors (52), der p-Kanal-Kaskodenschaltung (53-56) und der n-Kanal-Kaskodenschaltung (57-60).

11. Die Einrichtung nach Anspruch 10, wobei die Vorspannschaltung eine externe Stromquelle (70) und einen Schalttransistor (71) zum Abschalten der Vorspannschaltung und des Folded-Cascode-Transkonduktanz-Differenzverstärkers (20) aufweist.

12. Die Einrichtung nach Anspruch 4, ferner aufweisend einen Tri-State-Treiber (12) zum selektiven Koppeln der Einrichtung mit einem Bus (15).

13. Die Einrichtung nach Anspruch 4, ferner aufweisend:
Mittel (63) zum Ausgeben eines hohen logischen Signals aus der Einrichtung, wenn sich die Einrichtung in einem AusZustand befindet.

14. Die Einrichtung nach Anspruch 4, ferner aufweisend Mittel (62) zum Ausgeben eines niedrigen Logiksignals aus der Einrichtung, wenn die Einrichtung sich in einem Aus-Zustand befindet.

15. Ein Verfahren zum Konvertieren eines Differenzsignals (V_{indiff}) geringer Amplitude in ein zur Verwendung in digitalen Logikschaltungen geeignetes asymmetrisches Signal, wobei das Verfahren die Schritte aufweist:
Empfangen des Differenzsignals (V_{indiff}) geringer Amplitude in einem Folded-Cascode-Transkonduktanz-Differenzverstärker (20) zum Erzeugen eines ersten Ergebnissignals;
Weiterleiten des ersten Ergebnissignals zu einem selbstvorspannenden Inverter (22) zum Erzeugen eines zweiten Ergebnissignals;
Weiterleiten des zweiten Ergebnissignals durch einen zweiten Inverter (24) zum Erzeugen eines dritten Ergebnissignals, wobei das dritte Ergebnissignal ein asymmetrisches Signal ist, bei dem sämtliche Gleichtakteingangssignale aus dem Differenzsignal geringer Amplitude und Stromversorgungsrauschen unterdrückt sind; und
Verstärken des dritten Ergebnissignals auf digitale Logikpegel.

16. Das Verfahren nach Anspruch 15, wobei der Verstärkungsschritt den Schritt des Weiterleitens des dritten Ergebnissignals durch eine Kette miteinander gekoppelter Inverterschaltungen (26, 28, 30, 32) umfaßt.

17. Das Verfahren nach Anspruch 15, ferner umfassend den Schritt des Anlegens vorspannender Spannungen an den Folded-Cascode-Transkonduktanz-Differenzverstärker zum Betreiben und zum selektiven Ausschalten des Transkonduktanz-Verstärkers.

18. Das Verfahren nach Anspruch 15, ferner umfassend den Schritt des selektiven Tri-State-Pufferns des verstärkten Signals auf einen Bus.

19. Eine Einrichtung zum Konvertieren eines Differenzsignals (V_{indiff}) geringer Amplitude in ein zur Verwendung in digitalen Logikschaltungen geeignetes asymmetrisches Signal, wobei die Einrichtung aufweist:
einen Transkonduktanz-Differenzverstärker (20) zum Aufnehmen des Differenzsignals (V_{indiff}) geringer Amplitude und Unterdrücken irgendwelcher damit empfangenen Gleichtakteingangssignale, wobei der Transkonduktanz-Differenzverstärker das Differenzsignal geringer Amplitude in ein asymmetrisches Signal konvertiert;
einen mit dem Transkonduktanz-Differenzverstärker gekoppelten ersten Inverter (22), wobei der erste Inverter einen Eingang und einen Ausgang aufweist, wobei der Ausgang mit dem Eingang gekoppelt ist, um den ersten Inverter selbst-vorzuspannen;
einen mit dem Ausgang des ersten Inverters gekoppelten zweiten Inverter (24), welcher in dem ersten Inverter (22) vorhandenes Stromversorgungsrauschen unterdrückt; und
eine mit dem zweiten Inverter gekoppelte Verstärkungsschaltung (10) zum Verstärken eines sich ergebenden Signals auf digitale Logikpegel.

20. Die Einrichtung nach Anspruch 19, wobei die verstärkende Schaltung (10) eine Mehrzahl von Inverterschaltungen (26, 28, 30, 32) in einer Kette aufweist, um ein verstärktes Signal auf digitalen Logikpegeln zu erzeugen.

## Revendications

1. Dispositif pour la conversion d'un signal différentiel de faible amplitude (Vindiff) en un signal asymétrique adapté à une utilisation dans des circuits logiques numériques, ledit dispositif comprenant :
- un circuit de premier étage (5) pour recevoir ledit signal différentiel de faible amplitude, ledit circuit de premier étage rejetant sensiblement tout signal d'entrée en mode commun reçu et sensiblement tout bruit reçu d'alimentation en énergie, ledit circuit de premier étage convertissant, de plus, ledit signal différentiel de faible amplitude en un signal asymétrique ; et
- un circuit d'amplification de second étage (10) couplé audit circuit de premier étage (5) pour amplifier ledit signal asymétrique à des niveaux de signal logique numérique.

2. Dispositif selon la revendication 1, dans lequel ledit circuit de premier étage comprend :
- un transconducteur différentiel (20, 21) pour recevoir ledit signal différentiel de faible amplitude et pour rejeter toute entrée reçue en mode commun, ledit transconducteur différentiel convertissant ledit signal de tension différentielle de faible amplitude en un signal de courant asymétrique ;
- un premier inverseur (22) couplé audit transconducteur différentiel (20, 21), ledit premier inverseur possédant une entrée et une sortie parmi lesquelles ladite sortie est couplée à ladite entrée pour une auto-polarisation dudit premier inverseur ; et
- un second inverseur (24) couplé à la sortie dudit premier inverseur (22), rejetant tout bruit d'alimentation en énergie présent dans le premier inverseur.

3. Dispositif selon la revendication 2, dans lequel lesdits premier et second inverseurs (22, 24) ont des paires de transistors de classe équivalente.

4. Dispositif selon la revendication 2, dans lequel ledit circuit d'amplification de second étage (10) comprend une pluralité d'inverseurs (26, 28, 30, 32) selon une chaîne, chacun étant prévu pour inverser et amplifier, de façon progressive, un signal asymétrique reçu à partir dudit premier étage, élevant et amplifiant ledit signal à des niveaux adaptés à un actionnement de circuits logiques numériques.

5. Dispositif selon la revendication 4, dans lequel chaque inverseur de ladite pluralité d'inverseurs (26, 28, 30, 32) d'une chaîne possède des paires de transistors de même classe utilisant plusieurs transistors pour augmenter l'amplitude du signal.

6. Dispositif selon la revendication 4, dans lequel ladite pluralité d'inverseurs d'une chaîne comprend :
- des troisième et quatrième inverseurs (26, 28) possédant des paires de transistors de classe équivalente, lesdites paires de transistors étant équivalentes à la classe des paires de transistors dans lesdits premier et second inverseurs (22, 24) ;
- un cinquième inverseur (30) possédant une paire de transistors avec des classes de deux à trois fois la classe des paires de transistors dans lesdits troisième et quatrième inverseurs ; et
- un sixième inverseur (32) possédant une paire de transistors avec des classes de deux fois la classe de la paire de transistors dans ledit cinquième inverseur.

7. Dispositif selon la revendication 2, dans lequel ledit transconducteur différentiel est un transconducteur cascode replié différentiel (20).

8. Dispositif selon la revendication 7, dans lequel ledit transconducteur cascode replié différentiel (20) comprend :
- une paire de transistors d'entrée (50, 51) couplés pour recevoir ledit signal différentiel de faible amplitude ;
- un circuit cascode de canal p (53 à 56) couplé à ladite paire de transistors d'entrée ; et
- un circuit cascode de canal n (57 à 60) couplé audit circuit cascode de canal p ;
dans lequel un courant traversant ledit transconducteur est replié et forcé pour passer dans ledit premier inverseur (22).

9. Dispositif selon la revendication 8, dans lequel ledit transconducteur cascode replié différentiel (20) comprend, de plus, un transistor de courant de queue (52) couplé à ladite paire de transistors d'entrée (50, 51) pour faire passer un courant dans ladite paire de transistors d'entrée.

10. Dispositif selon la revendication 9, comprenant, de plus, un circuit de polarisation (voir la Figure 5) pour polariser ledit transistor de courant de queue (52), ledit circuit cascode de canal p (53 à 56) et ledit circuit cascode de canal n (57 à 60).

11. Dispositif selon la revendication 10, dans lequel ledit circuit de polarisation comprend une source de courant externe (70) et un transistor de commutation (71) pour couper ledit circuit de polarisation et ledit transconducteur cascode replié différentiel (20).

12. Dispositif selon la revendication 4, comprenant, de plus, un circuit d'attaque à trois états (12) pour un couplage sélectif dudit dispositif avec un bus (15).

13. Dispositif selon la revendication 4, comprenant, de plus, un moyen (63) pour fournir en sortie un signal logique haut à partir dudit dispositif lorsque ledit dispositif est dans un état bloqué.

14. Dispositif selon la revendication 4, comprenant, de plus, un moyen (63) pour fournir en sortie un signal logique bas à partir dudit dispositif lorsque ledit dispositif est dans un état bloqué.

15. Procédé pour la conversion d'un signal différentiel de faible amplitude (Vindiff) en un signal asymétrique adapté à une utilisation dans des circuits logiques numériques, ledit procédé comprenant les étapes suivantes :
- la réception dudit signal différentiel de faible amplitude (Vindiff) dans un transconducteur cascode replié différentiel (20) afin de produire un premier signal résultant ;
- la propagation dudit premier signal résultant vers un inverseur à auto-polarisation (22) pour produire un second signal résultant ;
- la propagation dudit second signal résultant par l'intermédiaire d'un second inverseur (24) pour produire un troisième signal résultant, ledit troisième signal résultant étant un signal asymétrique dans lequel toute entrée en mode commun à partir dudit signal différentiel de faible amplitude est rejetée et tout bruit d'alimentation en énergie est rejeté ; et
- l'amplification dudit troisième signal résultant à des niveaux logiques numériques.

16. Procédé selon la revendication 15, selon lequel ladite étape d'amplification comprend une étape de propagation dudit troisième signal résultant par l'intermédiaire d'une chaîne de circuits couplés d'inverseurs (26, 28, 30, 32).

17. Procédé selon la revendication 15, comprenant, de plus, une étape de fourniture de tensions de polarisation audit transconducteur cascode replié différentiel pour activer ledit transconducteur et pour couper, de façon sélective, ledit transconducteur.

18. Procédé selon la revendication 15, comprenant, de plus, une étape de conversion sur trois états dudit signal amplifié, de façon sélective, sur un bus.

19. Dispositif pour la conversion d'un signal différentiel de faible amplitude (Vindiff) en un signal asymétrique adapté à une utilisation dans des circuits logiques numériques, ledit dispositif comprenant :
- un transconducteur différentiel (20) pour recevoir ledit signal différentiel de faible amplitude (Vindiff) et pour rejeter une quelconque entrée en mode commun reçue avec ce dernier, ledit transconducteur différentiel convertissant ledit signal différentiel de faible amplitude en un signal asymétrique ;
- un premier inverseur (22) couplé audit transconducteur différentiel, ledit premier inverseur possédant une entrée et une sortie parmi lesquels ladite sortie est couplée à ladite entrée pour une auto-polarisation dudit premier inverseur ;
- un second inverseur (24) couplé à la sortie dudit premier inverseur, rejetant un bruit d'alimentation en énergie présent dans le premier inverseur (22) ; et
- un circuit d'amplification (10) couplé audit second inverseur pour amplifier un signal résultant à des niveaux logiques numériques.

20. Dispositif selon la revendication 19, dans lequel ledit circuit d'amplification (10) comprend une pluralité de circuits d'inverseur (26, 28, 30, 32) dans une chaîne pour produire un signal amplifié à des niveaux logiques numériques.
